# EUROPEAN PATENT APPLICATION

(11) **EP 2 924 757 A1**
(43) Date of publication of application: **30.09.2015**
(21) Application number: 14162288.6
(22) Date of filing: 28.03.2014
(51) Int. Cl.: H01L 51/52

(54) **Barrier film laminate and electronic device comprising such a laminate**

(71) Applicant: Nederlandse Organisatie voor toegepast- natuurwetenschappelijk onderzoek TNO, 2595 DA 's-Gravenhage (NL)
(72) Inventor: Michels, Jasper Joost, 2595 DA 's-Gravenhage (NL)
(74) Representative: Jansen, Cornelis Marinus

(57) **Abstract**

A barrier film laminate (1) comprising an organic layer (4) that is situated in between two inorganic layers (2,3) with pinholes. The pinhole density of the layers is less than ten million (5,6) per square metre. The barrier film laminate can be used for encapsulating organic electronic devices such as OLEDs.

## Description

The present invention relates to a barrier film laminate. More in particular, the invention relates to a barrier film laminate comprising a first inorganic layer with pinholes, a second inorganic layer with pinholes and an organic layer situated in between the first and the second inorganic layer. The invention also relates to an encapsulated organic electronic device comprising such a barrier film laminate.

### State of the art

An obstacle for the commercial exploitation of organic electronic devices such as Organic Light Emitting Diodes (OLEDs) for example for use in organic displays, organic photovoltaic cells (OPVs), and organic thin film transistors (OTFTs), is the deterioration of such devices under normal environmental conditions. In particular the exposure to oxygen and moisture contribute to a decline of the functional properties on a time-scale that is not acceptable for potential users of such devices. The relative fast deterioration of organic electronic devices is a hurdle that has to be taken for a successful introduction of such devices on the market, despite the advantages that such devices have compared to silicon based electronics. To slow down the deterioration of the devices, the devices are encapsulated by a material that is a good barrier for vapours and gasses, in particular for moisture and oxygen.

Devices on a non-flexible substrate can be encapsulated by for example a metallic cap. A disadvantage of a metallic cap is that it is neither flexible nor optically transparent. For the encapsulation of flexible devices, barrier laminates are applied. Barrier laminates are stacks of at least two planar layers. Such laminates are known for example from international patent application WO 01/81649. A first layer is made of an inorganic barrier material such as a metal oxide. A second layer of the barrier laminate is made of an organic material, usually a polymer. Often it is preferred to have a stack of more alternating layers of organic and inorganic material as disclosed in for example patent application US 2009/0098400.

Many inorganic materials are considered to be perfect barriers against moisture and oxygen. It is, however, in general recognised that such ideal materials do not provide a perfect barrier in practise. In for example internal patent application WO03/005461 it is disclosed that even layers of perfect barrier materials have small holes and other imperfections that allow the diffusion of vapours and gasses through such otherwise perfect barriers.

State of the art flexible OLEDs, OPVs and other organic electronic devices suffer from the lack of thin film barrier and encapsulation technology of sufficient high quality to guarantee end-user defined product life times.

### Summary of the invention

Deterioration of an organic electronic device means a decline of the functional properties of the device. The intensity of the light emitted by an OLED may be reduced or the distribution of the light intensity along the emitting surface may become nonhomogeneous. In particular, black spots may appear in the OLED due to local degradation of an electrode, for example by oxidation of the cathode. In particular because common low work-function metals, such as calcium or barium, are used which are not stable under the influence of air and moisture. A deterioration of an OLED may result in a change in the IV characteristics of the OLED due to for example physical or chemical changes at interfaces between different layers. In particular oxidation that occurs at interfaces within a device is a well-recognised origin of deterioration. The decline of the functional properties may finally result in a complete loss of any functionality, in which situation the OLED does emit no light anymore. In organic transistors, the deterioration may be manifested in a decreased current output and/or a suppressed mobility of the charge carriers resulting in a reduced charge transport in the transistor. A well-known origin for the degradation of such organic electronic devices is oxidation of electrodes and the trapping of charge carriers. Deterioration of organic photovoltaic cells results in a reduced light-to-power conversion efficiency.

It is an objective of the present invention to overcome the above mentioned problems of the state of the art in encapsulation of organic electronic devices. In particular it is an objective to provide a barrier film laminate that is a good moisture barrier.

This objective is obtained by a barrier film laminate comprising a first inorganic layer with pinholes, a second inorganic layer with pinholes and an organic layer situated in between the first and the second inorganic layer characterised in that the pinhole density in the first and the second inorganic layer is less than 10,000,000 (ten million) pinholes per square metre.

The effect of a pinhole number density less than ten million per square metre in the two inorganic layers is twofold. Firstly, such a low pinhole number density offers only a limited number of sites where vapours and gasses, in particular water vapour can pass the inorganic barrier material. Secondly, a low pinhole number density in both layers makes that the average distance between pinholes in the different layers is large. This effect of a low pinhole number density results in a low permeability of moisture through the barrier film laminate.

In an embodiment of the barrier film laminate the maximum equivalent pinhole diameter is 10 µm. The effect that pinholes in the inorganic layers are not larger than 10 µm is that there are no paths in the inorganic layer where the diffusion of water is hardly hindered. This results in less rejection of laminates after production on the basis of just a single or limited number of pinholes.

In another embodiment of the barrier film laminate the organic layer comprises a getter. The effect of a getter material being dispersed in the organic layer is that such organic layer can absorb moisture that permeates through an inorganic layer. This absorption prevents that all the moisture permeating through one of the inorganic layer will reach the other inorganic layer and permeate through the barrier film material.

It is another objective of the present invention to provide an organic electronic device having a long-term stability and good performance. This objective is obtained by an encapsulated organic electronic device comprising a barrier film laminate as described above. The effect of applying this barrier film laminate is that the permeation of moisture into the device will be slowed down significantly. Consequently, the deterioration of the electronic device will be delayed so that it will have a good performance during an acceptable term.

The present invention is based upon the insight that in particular for organic electronic devices such as OLEDs, the degradation or failure is not dominantly determined by an average and steady state permeation of water vapour through a barrier film laminate and that the local properties and the dynamics of the permeation are an important factor in the degradation and failure. So, barrier laminates should not only be designed to minimize an average or steady state water vapour transmission rate, but also or even preferably to minimize the pinhole density in the inorganic layers and the diffusion of water in the organic layer in between those inorganic layers. It is appreciated that were the term pinhole density is used, this term refers to the number of pinholes per unit area. The term pinhole number density is also used here.

The present invention will further be explained below with reference to exemplary embodiments illustrated in the accompanying drawings, in which:
- Fig. 1: schematically shows a barrier film laminate with a single organic layer;
- Fig. 2: schematically shows a barrier film laminate with two organic layers;
- Fig. 3: schematically shows a barrier film laminate comprising a substrate and a topcoat;
- Fig. 4: schematically shows an encapsulated organic electronic device;
- Fig. 5: schematically shows an encapsulated organic electronic device, the device being situated between a substrate and the barrier film laminate;
- Fig.6: schematically shows an encapsulated organic electronic device, the barrier film laminate being situated between a substrate and the device;
- Fig.7: schematically shows an OLED;
- Fig.8: encapsulated OLED showing pinholes in the barrier film laminate.

### Detailed description of the invention

A barrier film laminate can be applied to encapsulate an organic electronic device in order to reduce the amount of water entering the device. To obtain good barrier properties, the barrier film laminate comprises two inorganic layers, one inorganic layer at each side of an organic layer that is thus sandwiched between the inorganic layers. The inorganic layers provide an intrinsic high barrier property whereas the organic layer is helpful in planarizing, viz. mitigating roughness and a possible presence of particles. The organic layer may comprise organic materials, for example materials based on thermoset or thermoplastic materials. The class of organic materials that may be used comprises materials such as poly-urethanes and polyethers.

Each inorganic layer may be made of a single inorganic material or each layer may be made of a composition of two or more inorganic materials. Examples of inorganic materials that may be applied are metal or semiconductor oxides such as aluminium oxide and indium tin oxide, metal or semiconductor nitrides such as boron nitride and silicon nitride, or metal or semiconductor oxinitrides such as aluminium oxynitride or silicon oxinitride. Preferred are inorganic layers comprising SiₓOy, SiₓN_{y} or AlₓO_{y}. The compositions may be stoichiometric or not. The two inorganic layers may be made of the same material or the same composition or they may be made of different materials or different compositions.

The barrier properties of the inorganic layers are not only determined by the type of material but also by the thickness of the layers and, as will be discussed below, defects, in particular pinholes in the layers. These holes may be intrinsic to the network or created by defects, e.g. around particles. These holes may or may not have different size distributions. The two inorganic layers may have the same thickness or the layers may have a different thickness. The thickness of the inorganic layers in a barrier film laminate lies typically between 1 nm and 1000 nm, more in particular between 10 nm and 500 nm. For SiₓN_{y} layers a thickness between 20 nm and 300 nm may be preferred, more in particular between 50 nm and 250 nm. The inventors have observed that in particular SiₓN_{y} layers of about 150 nm thick are a good compromise between partly incompatible demands related to optical transparency, mechanical flexibility and barrier properties.

Inorganic barrier materials such as SiₓN_{y} have in general good intrinsic barrier properties which makes them in particular suitable for protecting organic electronic devices against moisture and oxygen. A good barrier means that the transmission of vapours and gasses that have a deteriorating effect on organic electronic devices is hindered significantly. Layers of such barrier materials as fabricated in practise are, however, not perfect. The layers contain pinholes. Pinholes are small imperfections or defects such as small holes. The origin of such small holes may be the presence of small impurities such as dust and particles origination from abrasion of mechanical parts of the processing equipment or from mechanical treatment of the foils and films being processed. The impurities trapped in the layer may be solid, liquid or gaseous. The origin may also be other imperfections during the growth or deposition of the layer. In crystalline materials or semi crystalline materials, pinholes may be imperfections in the crystal structure of the material.

The layers of the barrier film laminate can be obtained by any suitable method for making or depositing such layers. Such methods include but are not limited to methods in which a precursor material is deposited and from which precursor the required barrier material is obtained for example by a heat treatment or exposure to electromagnetic radiation such as ultraviolet light (UV). Suitable techniques for making or depositing the inorganic layers include physical vapour deposition (PVD) and chemical vapour deposition (CVD). Plasma-enhanced CVD (PECVD) is considered to be in particular suitable for depositing the inorganic materials of the inorganic layer of barrier film laminates because this technique allows deposition of materials at relative low temperatures which makes this deposition technique compatible with the use of organic materials in the barrier film laminate and organic electronic devices. Suitable techniques for making or depositing the organic layer include printing and coating. Out of the different printing techniques, inkjet printing may be chosen because it is particularly suited for making patterned structures from the materials used for making organic electronic devices. A preferred coating technique is slot-die coating. It will be appreciated that not all materials can be obtained and deposited by any of the techniques mentioned. Those skilled in the art know how to select the proper technique, whether mentioned above or not.

The inorganic layers or only one of the inorganic layers may be patterned or not. Patterning means here that the thickness of a layer need not to be the same over the whole area of the barrier film laminate. A layer may be patterned to allow for example bending of the laminate at a predetermined position. Patterning may also be used to allow the transmission of vapours or gasses at a certain position in for example a barrier film laminate for a sensor application.

The term "barrier film laminate" refers to a laminate that functions as a barrier against environmental influences such as moisture. The barrier film laminate according to the invention is in particular a good barrier against moisture. This laminate may, however, also be a good barrier against detrimental vapours and gasses such as oxygen. The word "film" refers to the fact that the laminate is thin in comparison to the other dimensions of the laminate. The film laminate may be a free standing laminate or a laminate that is deposited on a carrier such as a substrate or a device, for example an organic electronic device. Typically, the area of a barrier film laminate is in the range from a few square millimetres or a few square centimetres for encapsulation of single devices up to even tens or hundreds of square metres for a laminate on a roll for roll-to-roll application. The thickness of the barrier film laminates, in particular flexible laminates will be in general not be larger than 1 mm when it comprises a carrier substrate. Typically, the thickness of a laminate comprising a substrate may be 500 µm or thinner. Barrier film laminates without a substrate typically will be thinner than 10 micrometres, more in particular thinner than 1 µm.

A substrate may be made out of a single material or composition but it may also be a laminate of different materials. The substrate may for example be covered partly or completely by an organic layer at the side of the substrate where the barrier film laminate or the organic electronic device is deposited. In particular if an inorganic barrier layer is the first layer to be deposited on the substrate, such a substrate may comprise an organic surface layer, which layer may be advantageous to minimize the number of pinholes in the inorganic layer.

When reference is made to a layer that is positioned on top of another layer or on top of a substrate it is not to suggest any specific orientation with respect to the gravitational force. If a layer is on top of a substrate, the layer may be above or below the substrate. The same holds for a device and a substrate or layer.

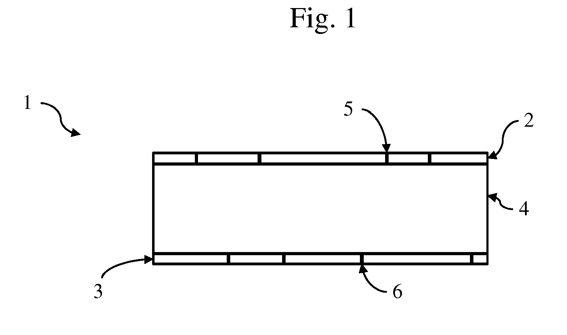

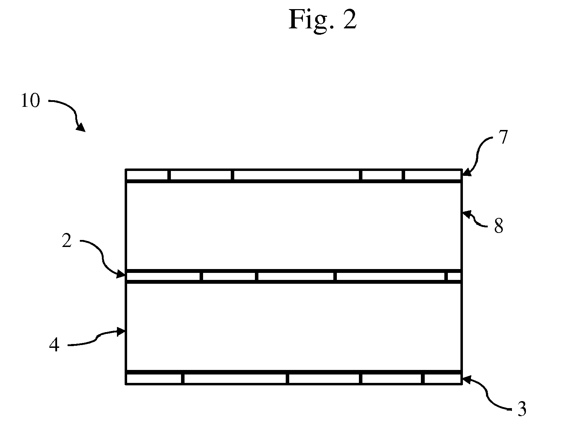

Figure 1 shows an embodiment of the barrier film laminate (1) with only one organic layer (4) sandwiched between two inorganic layers (2,3). Very schematically, also some pinholes (5,6) are shown in both inorganic layers. The drawing in this figure 1 and also the drawings in the figures 2 to 7, is for illustration only and the dimensions of the different layers and the size of the pinholes are not drawn to scale. One of the functions of the organic layer is to create a distance between the two inorganic layers. Consequently, the organic layer creates a distance between the pinholes in the upper and the lower inorganic layer. The larger the distance between pinholes in the upper and lower layer, the larger the path for the diffusion of water molecules through the barrier film laminate. The length of the diffusion path is not only determined by the thickness of the organic layer but also by the density of the pinholes. The higher the density of the pinholes, the smaller the average distance between pinholes in the two layers. For a more detailed analysis, the size and number distributions of the holes in each of the inorganic layers have to be taken into account. Such a distribution may give the probability that a pinhole with a given size in the first inorganic barrier layer has a certain distance to a pinhole with a given size in the second inorganic barrier layer.

The inventors have surprisingly found that a pinhole number density that is less than 10,000,000 (ten million) pinholes per square metre in each of the inorganic layers secures that the local degradation of an organic electronic device that is encapsulated by such a barrier laminate is supressed with a high degree of probability. In other words, a low pinhole density of this order results in a low rejection rate of laminates and devices encapsulated by such a barrier film laminate, in particular for areas up to tens of square centimetres. For certain applications the maximum pinhole number density may be 5,000,000 or 1,000,000 pinholes per square metre in order to obtain an acceptable low rejection rates of the devices encapsulated by the barrier film laminate. Specific barrier film laminates may have a pinhole density that is even lower that 100,000 or 10,000 per square metre.

The organic layer of the barrier film laminate may comprise a radiation curable resin, viz. a resin that can be solidified by electromagnetic radiation. Examples of such resins are UV-curable resins comprising an acrylate or a methacrylate. The organic layer may also comprise a solvent-based resin such as a curable formulation dissolved in a solvent or a polymer solution that only requires a drying step. Typically, the organic layer may have a thickness between 0.1 µm and 200 µm. However, in order to obtain an inorganic layer with a low pinhole density it is preferred to have a lower limit of the thickness that is at least a factor of ten higher, viz. a thickness higher than 1 µm or even higher than 10 µm. To obtain a sufficient decoupling of the two inorganic layers and a good planarization of the layer to mitigate the effect of possible impurities, the thickness is preferably between 20 µm and 100 µm.

In addition to the number density of the pinholes in the inorganic layers, the maximum size of the pinholes may be a discriminating parameter for acceptance or rejection of a barrier film laminate. The inventors have found that in particular a maximum equivalent pinhole diameter of 10 µm results in less rejection on the basis of just a single pinhole or limited number of pinholes. In general, pinholes may be round holes in the inorganic layers. For such holes the diameter is a measure for the area through which water can permeate. It is appreciated, however, that the pinholes may not be round and therefore the diameter is not a parameter for the area in strict sense. Here the term equivalent diameter is introduced. The equivalent diameter is the diameter that in case the pinhole is round, gives the same exposed area as the actual pinhole. Although a maximum equivalent diameter of 10 µm satisfies to obtain an rejection rate that is acceptable, a lower maximum equivalent diameter of for example 5 µm or even 1 µm may be preferred for a specific application.

The inventors have found that the density of the pinholes is a more relevant parameter for determining the local degradation than the commonly used water vapour transmission rate (WVTR). The WVTR is a relevant parameter for determining the average water vapour transmission through a laminate. In addition the WVTR relates to the steady state situation. The WVTR commonly is determined by a standard test methods such as ASTM F 149 *Standard Test Method for Water Vapor Transmission Rate Through Plastic Film and Sheeting.*

The WVTR as determined according to the above mentioned standard characterises the situation in which the amount of water vapour entering the barrier film laminate is equal to the amount of water vapour leaving the material. In particular in barrier film laminates in which the organic layer comprised dispersed getter particles, it will take a long term before a steady-state situation is obtained and it may be disputed whether this steady-state situation characterises the barrier properties adequately. For further discussion about the moisture permeation through laminates reference is made to literature, for example J. Greener, K.C. Ng, K.M. Vaeth, and T.M. Smith, Moisture Permeability Through Multilayered Barrier Films as Applied to Flexible OLED Display, J. Appl. Polymer Sci, vol. 106, 3534-3542 (2007).

In another embodiment of the barrier film laminate the water permeability in the organic layer is less than 1x10⁻¹⁰ mol/Pa.s, at a temperature of 60 degrees Celsius. A laminate of an organic layer with such a low permeability and two inorganic layers with a pinhole density less than ten million pinholes per square metre provides a good barrier, not only in the steady-state situation, but also before such a situation is reached. The permeability may be much less than 1x10⁻¹⁰ mol/Pa.s to improve the barrier properties further, for example the permeability may be 2x10⁻¹² mol/Pa.s or less.

To improve the performance of barrier film laminates a getter material may be incorporated in the laminate. Such getter materials can be incorporated as a continuous layer as disclosed in international patent application WO2006/082111. The getter material can also be incorporated in the organic layer that is sandwiched between the two inorganic layers. In such laminates the getter material may be dispersed in the organic layer as small particles, for example particles with a size in the submicron range, viz. particles that are not larger than 1 µm. Advantageous are powders with particles having an average diameter between 0.01 and 1 µm. Preferably the average dimensions of the getter particles dispersed in the organic layer are between 0.05 and 0.5 µm. The getter materials selected for incorporation in the laminate, either as a continuous layer or dispersed in the organic layer, are hygroscopic materials, viz. materials that can absorb or otherwise bind water. Suitable getter materials are for example calcium oxide (CaO), barium oxide (BaO), or magnesium oxide (MgO). Alternatively, depending on the chemical nature of the getter, the getter may also be molecularly dissolved in the liquid precursor formulation of the organic layer.

Another embodiment of the barrier film laminate comprises two organic layers (4,8). This embodiment will further be elucidated with reference to figure 2. The second organic layer (8) is situated on top of and in direct contact with the first inorganic layer (2). Of course, this second organic layer can also be situated on top of and in direct connection with the second inorganic layer (3). The second organic layer may have the function of protecting the inorganic layer. Such a protective layer is often referred to as a topcoat and it may provide protection against for example scratches and other mechanical damage. Typically, such an organic topcoat is made out of a radiation curable material such as an acrylate, methacrylate, epoxide, oxetane or a combination of one or more of these materials. The thickness of the topcoat is typically between 1 µm and 100 µm, preferably between 10 µm and 50 µm. The second organic layer may also be a substrate, preferably a foil for carrying the other layers of the laminate. A substrate will be needed if a freestanding barrier film laminate is aimed at and the laminate of the first organic layer and the two inorganic layers itself is too thin to be handled as a freestanding foil. Examples of such substrates are foils made from polypropylene (PP), polyphenylene sulphide (PPS), polyethylene naphthalate (PEN), polyether sulfone (PES), or polyethylene terephthalate (PET) foil. Typical thicknesses of such foils are between 1 µm and 500 µm or more particular between 50 µm and 250 µm.

The barrier film laminate may further comprise a third inorganic layer (7) situated on top of the second organic layer (8). This embodiment of the barrier film laminate comprising three inorganic barrier layers may be preferred if further improvement of the barrier properties is aimed at in comparison to the barrier film layer shown in figure 1. When further improvement is aimed at, the laminate may comprise a getter material dispersed in the second organic layer as described above for the first organic layer.

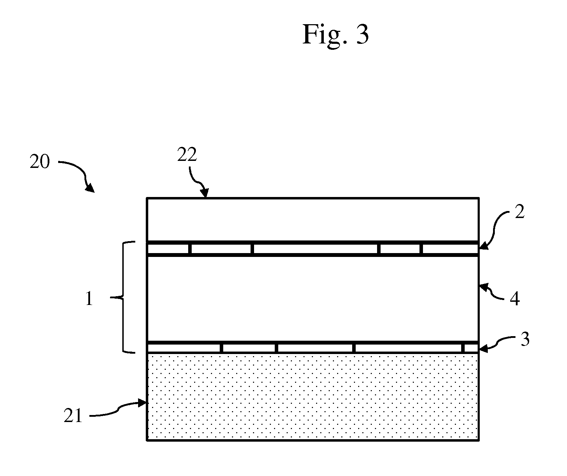

As mentioned above, the barrier film laminate may comprise a substrate. An embodiment of the laminate comprising a substrate (21) is shown in figure 3. This embodiment is a stack of a substrate (21), a first inorganic layer (2), an organic layer (4) and a second inorganic layer (3). The second inorganic layer is situated on top of and in direct contact with the substrate. So, the barrier film laminate is a stack of subsequently a substrate (21), an inorganic layer (3), an organic layer (4), and an inorganic layer (2). The substrate may be a substrate that is coated with for example an organic planarization or adhesion layer forming an intermediate layer between the inorganic layer and the bulk of the substrate. Although an organic foil is preferred as a substrate because of its flexibility, also other types of substrates can be used. The substrate may for example be a glass or ceramic substrate. The substrate may also be a metallic substrate, in particular a metallic foil. Depending on the use that is aimed at, the substrate may be optical transparent, either clear or opaque, or the substrate may be non-transparent for light. A transparent barrier laminate is in particular suited for the encapsulation of optoelectronic devices such as OLEDs because such a laminate can also be applied on the light emitting side of the OLED. The first inorganic layer (2) may be covered, either partly or completely, with a topcoat (22) to protect the stack, more in particular the upper inorganic layer, against damage.

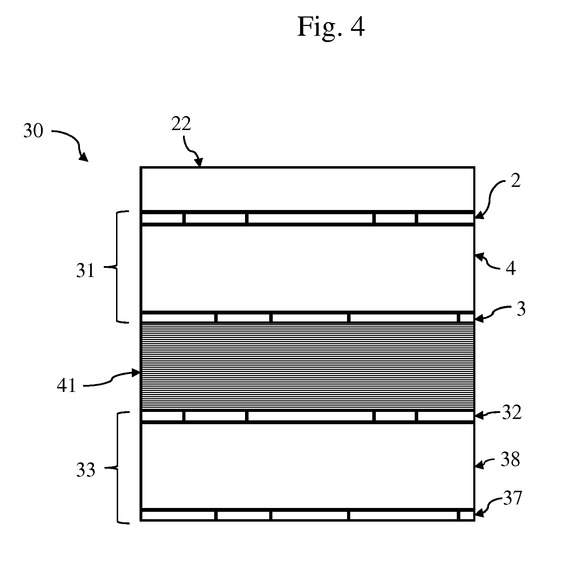

The invention also relates to an encapsulated organic electronic device comprising a barrier film laminate. An embodiment of an encapsulated electronic device (30) is shown in figure 4. Examples of organic electronic devices are Organic Light Emitting Diodes (OLEDs). organic photovoltaic cells (OPVs), organic thin film transistors (OTFTs), and organic memory devices. According to this embodiment, the bare organic electronic device (41) is encapsulated at two opposite sides by a barrier film laminate (31,33). According to the embodiment of figure 4, both barrier film laminates comprise an organic layer sandwiched between two inorganic layers. The two barrier laminates may be identical, but they also be different. The organic layers (4,38) of the two barrier film laminates may have different thicknesses, they may have a different compositions, or they may be different both in thickness and in material composition. One or both the organic layers may comprise a getter material for absorbing moisture. Also the four inorganic layers (2,3,32,37) may be the same or different in one or more aspects, more in particular in thickness and material composition.

The encapsulated organic electronic device as shown in figure 4 may be supported by a substrate. In general, an organic electronic device comprises a substrate to allow the device to be handled. The substrate may be for example a glass substrate or a polymeric foil coated with a barrier, for example a barrier film laminate comprising an organic layer sandwiched between two inorganic layers.

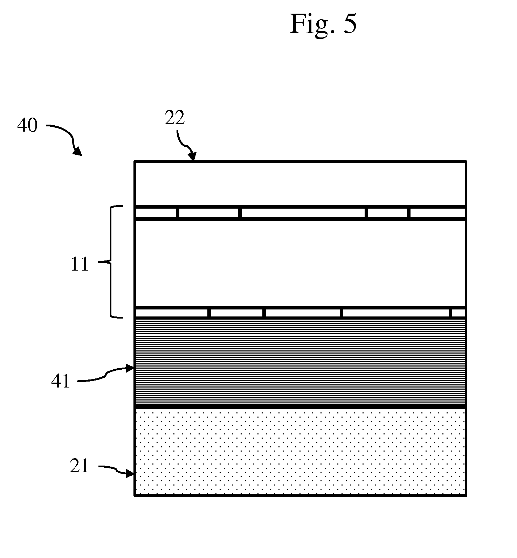

In figure 5 an embodiment of an encapsulated organic electronic device (40) is shown in which the bare organic electronic device (41) is situated in between the substrate (21) and the barrier film laminate (11). According to this embodiment of the encapsulated organic electronic device, the bare device (41) is positioned or deposited on top of a substrate (21). Often, the bare device itself comprises several layers that are subsequently deposited on the substrate. Such a bare device may be an OLED as described below. It may however also be an OPV or an OTFT. On top of the bare device, so at the side of the bare device opposite to the substrate, a barrier film laminate (11) is situated. This laminate comprises an inorganic layer sandwiched between two inorganic layers. Several embodiments of the barrier film laminate can be applied, including those described above. Embodiments of the barrier film laminate shown in the figures 1 and 2 will preferably be deposited layerwise on the bare device by a suitable deposition technique. Barrier film laminates comprising a substrate, for example the one shown in figure 3, may be applied by a laminating process known from lamination of foils.

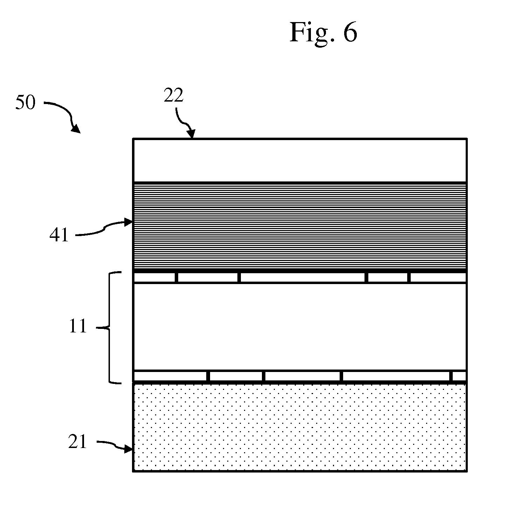

In another embodiment of the encapsulated organic electronic device (50), shown in figure 6, the barrier film laminate (11) is situated in between the substrate (21) and the organic electronic device (41). In such an embodiment, the device may be protected by a topcoat (22). The topcoat in this encapsulated device needs to have barrier properties. Layers having good barrier properties are for example glass substrates, metallic layers, and barrier film laminates as described before. In an embodiment where the top layer is a laminate as shown in figure 1, the encapsulated device is actually the one shown in figure 4, further comprising a substrate.

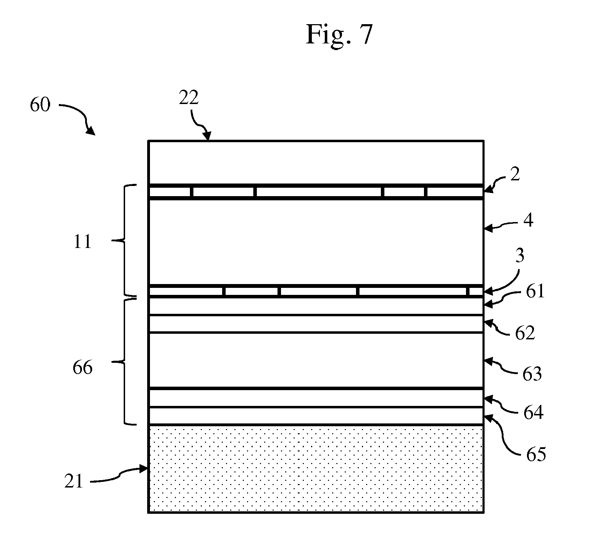

An example of an organic electronic device, more particular an encapsulated organic optoelectronic device is an OLED. The generic structure of such an OLED will be elucidated with reference to figure 7. This figure 7 is also used to elucidate the effect of pinholes in the inorganic layers of the barrier film laminate on the performance of the device.

The OLED is deposited on a transparent substrate (21). Here a glass substrate is used that provides a good barrier against water vapour. The bare OLED (66) is situated on top of the glass substrate. In case that the substrate is not a good barrier against moisture, for example if the substrate is a polymeric foil, than the substrate may be covered with a barrier. Preferably that is a barrier film laminate as shown in figure 1, viz. a barrier comprising an organic layer that is sandwiched between two inorganic layers. The layer of the OLED that is in direct contact with the substrate is an ITO layer (65). This ITO layer and a PEDOT:PSS (64) layer deposited on the ITO, form the hole injecting anode of the OLED. Here a PEDOT:PSS layer with a thickness of 100 nm is applied. The light emitting layer (63) that is deposited on top of the PEDOT:PSS layer, here is a light emitting polymer (LEP) comprising a polyspirofluorene backbone either or not comprising hole accommodation units and/or energy transfer dyes to tune the wavelength of the emitted light. Other materials that may be used in the electroluminescent layer of an OLED are for example derivatives of poly(p-phenylene vinylene) (PPV) and polyfluorene (PF) and materials such a poly(3-hexylthiophene) (P3HT). The cathode of the OLED is deposited on top of the LEP and is a combination of two layers. A thin layer (62) of a low work-function metal is deposited in direct contact with the LEP. Here this thin layer is a 5 nm thin barium layer. In other devices other metal may be used, for example calcium. The barium layer of the OLED is covered with a second metallic layer (61), here a 100 nm thick aluminium layer.

The bare OLED, which may comprise additional layers, is covered by a barrier film laminate (11)3. In the device shown in figure 7, the barrier laminate is the one shown in figure 1. More in particular the organic layer is a 40 µm thick layer of a low-VOC, solventless UV curable acrylic formulation comprising 5 weight % of the getter material CaO. The inorganic layers (2,3) are 150 nm thick SiN layers. To protect the encapsulated device from mechanical damage, for example scratches , a 20 µm thick top coat (22), which for example may comprise a low-VOC, solvent-less radiation curable formulation optimized for scratch resistance.

For OLEDs a WVTR (Water Vapour Transmission Rate) of 10⁻⁶ g/m2/day is frequently mentioned as a limiting value. Such a low transmission rate may be determined with the calcium test. This test is well known to those skilled in art. As an example reference is made to the publications: G. Nisato, P. Bouten, P. Slikkerveer, W. Bennett, G. Graf, N. Rutherford, L. Wiese, Proc. Asia Display 2001, 1435; and D. Spee, K. van der Werf, J. Rath, and R. Schropp, Excelent organic/inorganic transparent thin film moisture barrier entirely made by hot wire CVD at 100 °C, Phys. Status Solidi RRL, 1-3 (2012). Another way to quantify the performance of the barrier layer is to follow the behaviour of an organic electronic device, such as an OLED, in time. Non-functional black spots are formed upon local water ingression in the device. This type of testing is preferred by the inventors as it indicates local degradation and is therefore more informative than the determination of an overall WVTR value. High quality barrier layers require accelerated tests to observe cell degradation within practically feasible time frames. Experiments are then performed under more severe conditions. Presently, accelerated lifetime testing is frequently done at 60 °C and 90 % RH (relative humidity).

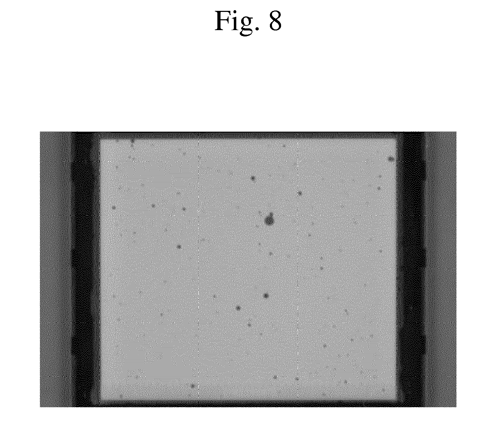

The encapsulated OLED shown in figure 7 will be used to illustrate how the pinhole density of an organic layer in the barrier film laminate can be determined experimentally. The barrier layer of this OLED is a stack of four layers. An organic layer (4) comprising a calcium oxide getter is sandwiched between two inorganic layers (2,3). On top of these three layer a topcoat (22) is deposited. In the OLED, see figure 7, is this barrier film laminate is situated at the back side of the bare OLED (66), viz. on the side that does not emit light. Figure 8 shows a photograph from the back side of the encapsulated OLED after the OLED has been exposed for more than 1000 hours to conditions for accelerated aging. The conditions chosen here are 60 degrees Celsius and 90 % relative humidity. The size of the active area of the OLED shown in figure is 5 cm by 5 cm. For testing of barrier film laminates that will be applied for encapsulating organic electric devises it is preferred to measure the barrier properties on an area that is approximately the same as the area of the device that has to be encapsulated.

Water vapour that permeates through the upper inorganic layer (2) will react with the dispersed getter calcium oxide (CaO) into calcium hydroxide (Ca(OH)₂) :

CaO + H₂O -> Ca(OH)₂

In the area where the reaction from calcium oxide into calcium hydroxide has taken place, there will be a scattering of light because the organic matrix material comprising the dispersed calcium oxide has a refractive index that is different from the refractive index of the organic matrix material comprising calcium hydroxide. In the photograph of figure 7, areas comprising calcium hydroxide can be seen as dark spots. By means of image analysis the number and size of these areas comprising calcium hydroxide can be determined. Although the inventors do not want to be bound to any theory, they assume that if the various areas as observed in this way do not overlap, each of these areas corresponds to a pinhole in the barrier layer. A saturated area represents a quantity of locally in-fluxed water vapour. With known CaO concentration and testing time the size of the saturated area can be interpolated to yield the equivalent diameter of the corresponding pinhole.

Water vapour that passes through the barrier laminate will reach the cathode of the OLED. Here the water may react with the reactive material, in particular the barium, of the cathode. This reaction my be an oxidation process that makes the cathode partly nonconductive. This deterioration of the cathode will result in so called black spots in the OLED. These non-emissive spots are considered to be due to hindered electron injection resulting from local loss of work function and/or the presence of a charge tunnelling barrier as a result of the oxidation process. The growth rate of the black spots depends on the testing climate, as well as the water vapour sorption and transport properties of the active layers in the OLED itself. The light emitting side of the OLED, viz. the side of the transparent substrate (21) will have non-emitting areas when looking from the front side. Such black spot, that can be related to the pinholes in the barrier layers, are not acceptable for users and therefore should be avoided. It will be appreciated that also this phenomenon can be used to determine the pinhole density and the size.

Although the barrier film laminate has been developed for the encapsulation of organic electronic devices, the laminate may also be applied for encapsulation of other devices and products that are very sensitive to deterioration by water vapour.

## Claims

1. Barrier film laminate (1) comprising a first inorganic layer (2) with pinholes, a second inorganic layer (3) with pinholes and an organic layer (4) situated in between the first and the second inorganic layer **characterised in that** the pinhole density of the first and second inorganic layer is less than ten million pinholes (5,6) per square metre.

2. Barrier film laminate according to claim 1, wherein the maximum equivalent pinhole diameter is 10 µm.

3. Barrier film laminate according to any of the preceding claims, wherein the organic layer has a water permeability of less than 1x10⁻¹⁰ mol/Pa.s at 60 degrees Celsius.

4. Barrier film laminate according to any of the preceding claims, comprising a getter material.

5. Barrier film laminate according to claim 4, wherein the getter material is dispersed in the organic layer.

6. Barrier film laminate according to claim 4 or 5, wherein the getter material is calcium oxide, barium oxide, or magnesium oxide.

7. Barrier film laminate (10) according to claim 1, comprising a second organic layer (8) on top of the first inorganic layer (2) and a third inorganic layer (7) on top of this second organic layer.

8. Barrier film laminate (20) according to any of the preceding claims, comprising a substrate (21).

9. Barrier film laminate according to claim 8, wherein the substrate is a flexible substrate.

10. Barrier film laminate according to claim 8 or 9, wherein the substrate is transparent.

11. Encapsulated organic electronic device (30) comprising a bare organic electronic device (41) and a film barrier laminate (11) according to any of the claims 1 to 7.

12. Encapsulated organic electronic device (40) comprising a bare organic electronic device (41) and a barrier film laminate (11) according to any of the claims 8 to 10, wherein the bare organic electronic device is situated in between the substrate (21) and the barrier film laminate (11).

13. Encapsulated organic electronic device (50) comprising a bare organic electronic device (41) and a barrier film laminate (11) according to any of the claims 8 to 10, wherein the barrier film laminate (11) is situated in between the substrate (21) and the bare organic electronic device (41).

14. Organic electronic device according to claim 11, wherein the organic electronic device comprises an organic light emitting diode.

15. Organic electronic device according to claim 11, wherein the organic electronic device comprises an organic thin film transistor.
